(19) Europäisches Patentamt / European Patent Office / Office européen des brevets

(11) **EP 3 968 742 A1**

(12) **EUROPEAN PATENT APPLICATION**

(43) Date of publication:
**16.03.2022 Bulletin 2022/11**

(21) Application number: **21194694.2**

(22) Date of filing: **03.09.2021**

(51) International Patent Classification (IPC):
**H05K 7/14** *(2006.01)*　　**H05K 7/20** *(2006.01)*

(52) Cooperative Patent Classification (CPC):
**H05K 7/1432; H05K 7/20927**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **11.09.2020 JP 2020152574**

(71) Applicant: **TOYOTA JIDOSHA KABUSHIKI KAISHA**
**Toyota-shi, Aichi-ken, 471-8571 (JP)**

(72) Inventors:
• **THANH, Le Dinh**
**Toyota-shi, 471-8571 (JP)**
• **ICHINOSE, Kenichi**
**Toyota-shi, 471-8571 (JP)**
• **WATARI, Toshio**
**Toyota-shi, 471-8571 (JP)**
• **MORIMOTO, Ryota**
**Toyota-shi, 471-8571 (JP)**
• **HASHIMOTO, Ayumi**
**Toyota-shi, 471-8571 (JP)**
• **YOSHIMOTO, Hiroshi**
**Toyota-shi, 471-8571 (JP)**

(74) Representative: **J A Kemp LLP**
**80 Turnmill Street**
**London EC1M 5QU (GB)**

(54) **POWER CONVERTER**

(57)　A power converter (100) includes a power card (30) that houses switching elements (10) therein, an electrically conductive cooler (40) that is in contact with the power card (30) with an insulation plate (30a) disposed between the cooler (40) and the power card (30), and a grounded electrically conductive case (50) that houses the power card (30) and the cooler (40) therein, wherein the power converter (100) converts power through switching operation of the switching elements (10), and wherein the cooler (40) is attached to the case (50) with an insulation spacer (61, 62) and an insulation tube (63) disposed between the cooler (40) and the case (50).

FIG. 1

EP 3 968 742 A1

**Description**

CROSS REFERENCE TO RELATED APPLICATION

This application claims priority to Japanese Patent Application No. 2020-152574 filed on September 11, 2020, which is incorporated herein by reference in its entirety including the specification, claims, drawings, and abstract.

TECHNICAL FIELD

The present disclosure relates to a structure of a power converter.

BACKGROUND

Power converters including a switching element such as insulated-gate bipolar transistors (IGBTs) and power metal oxide semiconductor field-effect transistors (power MOSFETs) for converting the voltage of direct current power or convert direct current power into alternating current power have often been used recently. Due to heat generated by switching operation of a switching element, a metal cooler made of, for example, an aluminum or copper block is attached to the switching element with an insulation material disposed between the switching element and the metal cooler (refer to, for example, background art described in JP 2013-84800 A).

A switching element and a cooler are housed in a grounded metal case, and then installed in, for example, an electric vehicle. Such a configuration generates stray capacitance between the switching element and the ground. It is known that, in response to switching operation of the switching element, common mode current flows from a line such as a ground wire of a motor connected to a power converter for driving a vehicle, through the ground, and returns to the switching element, thereby generating common mode noise (refer to, for example, background art of JP H09-298889 A).

In response to this issue, there has been proposed a configuration including a ceramic cooler to reduce stray capacitance between the switching element and the grounded case and suppress common mode noise (refer to, for example, JP H09-298889 A).

Further, there has been proposed a configuration in which an insulation substrate including an insulation layer and a frame made of magnetic material is interposed between a switching element and a cooler to reduce common mode current (refer to, for example, JP 2017-162988 A).

SUMMARY

A power converter that converts large-capacity electric power has been used recently. In such a case, because a large amount of heat is produced from a switching element, a metal cooler as described in JP 2013-84800 A is often used, rather than a ceramic cooler described in JP H09-298889 A. In such a case, even if an insulation material is interposed between a switching element and a cooler as described in JP 2013-84800 A and JP 2017-162988 A, a large amount of stray capacitance between the switching element and the ground occurs when a metal cooler is in contact with a grounded case, and increases common mode noise.

An object of the present disclosure is to suppress common mode noise in a power converter that incorporates an electrically conductive cooler.

According to one aspect of the present disclosure, there is provided a power converter comprising: switching elements; an electrically conductive cooler that is in contact with the switching elements with an insulation plate disposed between the cooler and the switching elements; and a grounded electrically conductive case that houses therein the switching elements and the cooler, wherein the power converter converts power through switching operation of the switching elements, and wherein the cooler is attached to the case with an insulation member disposed between the cooler and the case.

According to this configuration, the stray capacitance between the switching elements and the ground resembles a stray capacitance in which a minute stray capacitance between the cooler and the case is connected in series to a stray capacitance that would occur between the switching elements and the ground when no insulation member is provided, thereby reducing the stray capacitance between the switching elements and the ground. This configuration suppresses common mode current returning to the switching elements through the ground and suppresses occurrence of common mode noise when switching operation of the switching elements.

According to another aspect of the present disclosure, there is provided a power converter comprising a plurality of power cards each housing switching elements; and a plurality of electrically conductive coolers, each of which is in contact with one or more power cards of the plurality of power cards with an insulation plate disposed between the cooler and each of the one or more power cards, wherein the plurality of coolers and the plurality of power cards are stacked with an insulation plate interposed between each of the plurality of coolers and its adjacent power card to form a stack, and wherein the stack is attached to the case with an insulation member interposed between each of two of the plurality of coolers that are located at opposite ends in a stacking direction and the case.

This configuration enables insulation between the coolers and the case in a simple manner.

According to still another aspect of the present disclosure, there is provided a power converter, wherein each of the plurality of coolers comprises: a plate heat exchanger having a coolant flow passage therein and having an outer surface that is in contact with a surface of its adjacent power card with an insulation plate disposed between the heat exchanger and the power card; and pipe portions each connected to one of two ends of the heat exchanger and extending in the stacking direction, each of the pipe portions having an inner through hole that is in communication with the coolant flow passage of the heat exchanger, wherein the pipe portions of the plurality of coolers with the heat exchangers placed between the plurality of power cards are connected to each other in the stacking direction to form coolant pipes that extend in the stacking direction, wherein the pipe portions of one of the plurality of coolers that is located at one end in the stacking direction penetrate and extend out the case, and wherein the pipe portions that penetrate the case are attached to the case with a different insulation member disposed between each of the pipe portions and the case.

By insulating between the pipe portions of the coolers penetrating the case and the case as described, the stray capacitance between the switching elements and the ground can be made smaller, thereby suppressing common mode noise more effectively.

According to still another aspect of the present disclosure, there is provided a power converter, wherein the pipe portions of the plurality of coolers are connected to each other with an insulation ring disposed between each of the pipe portions and its adjacent pipe portion.

This configuration prevents the sum of the individual stray capacitances between each of the power cards and the ground to be the stray capacitance between the stack and the ground so that the individual stray capacitances between each of the power cards and the ground can be taken as the stray capacitance between the stack and the ground. Accordingly, the stray capacitance between the switching elements and the ground can be reduced, thereby reducing common mode noise.

According to still another aspect of the present disclosure, there is provided a power converter comprising: a plurality of power cards each housing switching elements; a plurality of electrically conductive coolers, each of which is in contact with one or more power cards of the plurality of power cards with an insulation plate disposed between the cooler and each of the one or more power cards; and a grounded electrically conductive case that houses therein the plurality of power cards and the plurality of coolers; wherein the power converter converts power through switching operation of the switching elements, wherein the plurality of coolers and the plurality of power cards are stacked with the insulation plates interposed between the plurality of coolers and the plurality of power cards to form a stack, wherein each of the plurality of coolers comprises: a plate heat exchanger having a coolant flow passage therein and having an outer surface that is in contact with a surface of its adjacent power card with an insulation plate disposed between the heat exchanger and the power card; and pipe portions each connected to one of two ends of the heat exchanger and extending in the stacking direction, each of the pipe portions having an inner through hole that is in communication with the coolant flow passage of the heat exchanger, and wherein the pipe portions of the plurality of coolers with the heat exchangers placed between the plurality of power cards are connected to each other in the stacking direction with an insulation ring disposed between each of the pipe portions and its adjacent pipe portion to form coolant pipes that extend in the stacking direction.

This configuration prevents the sum of the individual stray capacitances between each of the power cards and the ground to be the stray capacitance between the stack and the ground so that the individual stray capacitances between each of the power cards and the ground can be taken as the stray capacitance between the stack and the ground. Accordingly, the stray capacitance between the switching elements and the ground can be reduced, thereby reducing common mode noise. Further, this configuration suppresses common mode noise even when the coolers and the case are not insulated from each other or insulation fails.

The present disclosure suppresses common mode noise in a power converter that incorporates electrically conductive coolers.

BRIEF DESCRIPTION OF DRAWINGS

Embodiments of the present disclosure will be described based on the following figures, wherein:

FIG. 1 is an exploded perspective view illustrating a power converter according to an embodiment;
FIG. 2 is a cross section as viewed from the directions shown by arrows A-A in FIG. 1, and illustrates a plan cross sectional view of a plane passing through the centers of coolant pipes for coolers shown in FIG. 1;
FIG. 3 is a cross sectional view as viewed from the directions shown by arrows B-B in FIG. 1 and illustrates an elevational cross sectional view of a vertical plane passing through the center of the coolant pipe for the coolers shown in FIG. 1;

FIG. 4 is a circuit diagram illustrating a motor drive system that converts direct current power from a battery into alternating current power to drive a motor using the power converter according to the embodiment, and flows of common mode current during switching operation of switching elements;

FIG. 5 is a partial circuit diagram illustrating the structure of a power converter according to a comparative example;

FIG. 6 is a plan cross sectional view of a plane passing through the centers of coolant pipes for coolers of a power converter according to another embodiment;

FIG. 7 is a plan cross sectional view of a plane passing through the centers of coolant pipes for coolers of a power converter according to another embodiment; and

FIG. 8 is an elevational cross sectional view of a power converter according to another embodiment.

DESCRIPTION OF EMBODIMENTS

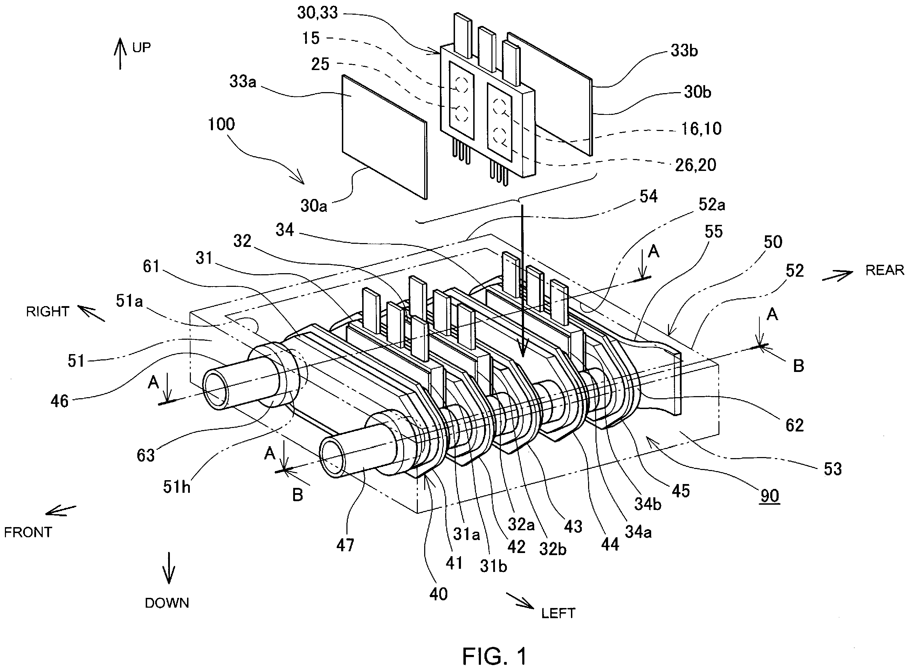

The following describes a power converter 100 according to an embodiment. As shown in FIG. 1, the power converter 100 according to an embodiment includes power cards 30 each housing switching elements 10 therein, coolers 40 that are each in contact with one or more the power cards 30 with insulation plates 30a and 30b disposed between the cooler 40 and each of the one or more the power cards 30, a case 50 that houses the power cards 30 and the coolers 40, insulation spacers 61 and 62 that serve as insulation members attached between the coolers 40 and the case 50, and an insulation tube 63. Each of the power cards 30 described herein includes two sets of one of switching elements 10 such as insulated gate bipolar transistors (IGBTs) and one of diodes 20 connected in anti-parallel to the switching element 10. The coolers 40 and the case 50 are made of metal such as aluminum. Thus, the coolers 40 and the case 50 have electrical conductivity.

As shown in FIG. 1, first to fourth power cards 31 to 34 and first to fifth coolers 41 to 45 alternately stacked form a stack 90 with insulation plates 31a to 34a and 31b to 34b interposed therebetween. In the following description, the four power cards are referred to as the first to the fourth power cards 31 to 34 when referred to individually, and are collectively referred to as the power cards 30. Similarly, the insulation plates 30a are individually referred to as 31a to 34a, and the insulation plates 30b are individually referred to as 31b to 34b. The five coolers are individually referred to as the first to the fifth coolers 41 to 45, and are collectively referred to as the coolers 40. Two sets, each consisting of one of the switching elements 10 and one of the diodes 20, are included in each of the first to the fourth power cards 31 to 34, and are individually referred to as first to eighth switching elements 11 to 18 and first to eighth diodes 21 to 28. In the following description, the stacking direction of the power cards 30 and the coolers 40 is referred to as the front/rear direction, the direction in which a coolant supply pipe 46 and a coolant discharge pipe 47 are arranged as the right/left direction, and the direction perpendicular to the front/rear and the right/left directions as the up/down direction. In the description herein, the side on which the coolant supply pipe 46 and the coolant discharge pipe 47 penetrate the case 50 to extend outward in the stacking direction is referred to as the front, the opposite side is referred to as the rear, a right-hand side as viewed from a position facing forward is referred to as a right side, and the opposite side is referred to as the left side. The case 50 is a substantially rectangular cuboid casing, but FIG. 1 shows only a front plate 51, a back plate 52, a right plate 54, and a left plate 53, and does not show a lid and a base plate.

As shown in FIG. 1, the third power card 33 is interposed between the third cooler 43 and the fourth cooler 44 and cooled from both front and rear surfaces. The insulation plate 33a is interposed between the front surface of the third power card 33 and the third cooler 43, and the insulation plate 33b is interposed between the rear surface of the third power card 33 and the fourth cooler 44. The insulation plates 33a and 33b electrically insulate the fifth and the sixth switching elements 15 and 16 and the fifth and the sixth diodes 25 and 26, housed in the third power card 33, from the third cooler 43 and the fourth cooler 44.

Similarly, the first power card 31 is interposed between the first cooler 41 and the second cooler 42 with the insulation plates 31a and 31b disposed therebetween, the second power card 32 is interposed between the second cooler 42 and the third cooler 43 with the insulation plates 32a and 32b disposed therebetween, and the fourth power card 34 is interposed between the fourth cooler 44 and the fifth cooler 45 with the insulation plates 34a and 34b disposed therebetween.

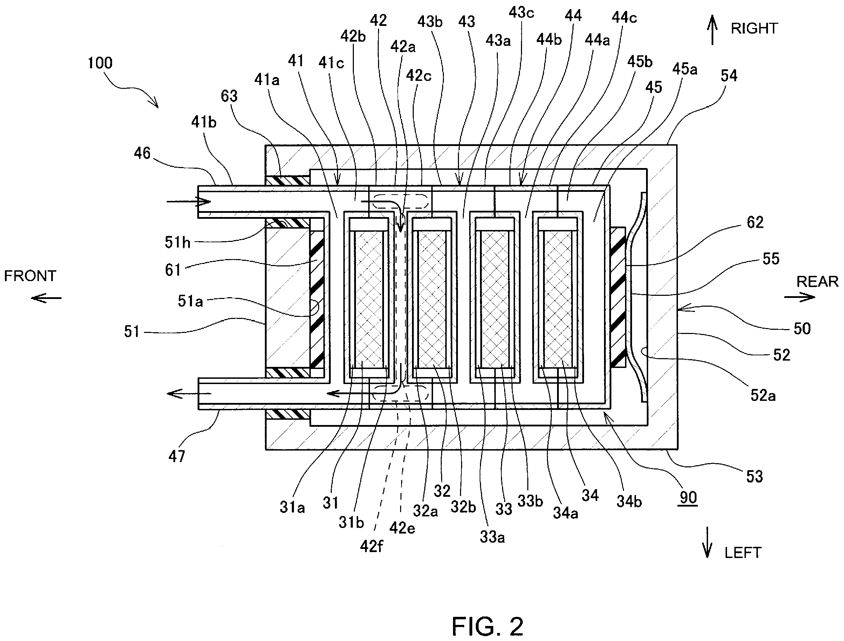

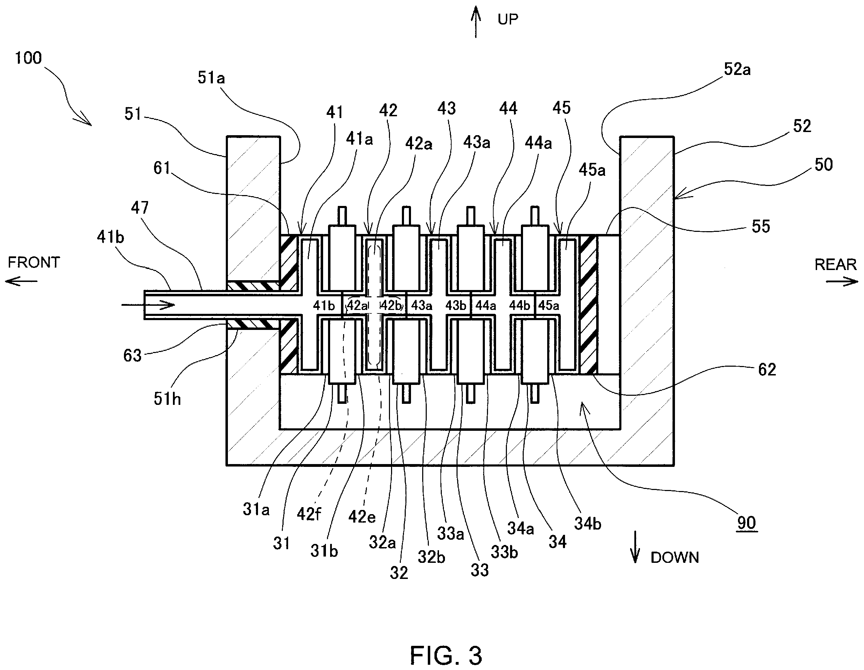

As shown in FIGs. 2 and 3, the second cooler 42 includes a heat exchanger 42a, front pipe portions 42b, and rear pipe portions 42c. The heat exchanger 42a is a plate portion having a coolant flow passage 42e extending inside in the right/left direction, and has a front surface contacting a rear surface of the first power card 31 with the insulation plate 31b disposed therebetween and a rear surface contacting the front surface of the second power card 32 with the insulation plate 32a disposed therebetween. The front pipe portions 42b are connected to the right and left ends of the heat exchanger 42a on the front side. Each of the front pipe portions 42b extends in the stacking direction, and has an inner through hole 42f that is in communication with the coolant flow passage 42e of the heat exchanger 42a. The rear pipe portions 42c are connected to the right and left ends of the heat exchanger 42a on the rear side. Each of the rear pipe portions 42c extends in the stacking direction, and has the inner through hole 42f that is in communication with the coolant flow passage 42e of the heat exchanger 42a. Similarly, the third and fourth coolers 43 and 44 respectively include heat exchangers 43a and 44a, front pipe portions 43b and 44b, and rear pipe portions 43c and 44c that have similar shapes to those of the heat exchanger 42a, the front pipe portions 42b, and the rear pipe portions 42c of the second cooler 42. The first cooler 41 includes a heat exchanger 41a and rear pipe portions 41c having similar shapes to those of the heat exchanger 42a and the rear pipe portions 42c, while front pipe portions 41b are elongated and extend toward the front in the stacking direction. Additionally, the fifth cooler 45 includes only a heat exchanger 45a and front pipe portions 45b and does not have rear pipe portions. The first, and the third to the fifth coolers 41, and 43 to 45 have coolant flow passages having a similar shape to that of the coolant flow passage 42e of the second cooler 42. The third and fourth coolers 43 and 45 include through holes having similar shapes to that of the through hole 42f of the second cooler 42. The first and the fifth coolers 41 and 45 have through holes having a similar shape to that of the through hole of the second cooler 42 except that they have different lengths in the stacking direction.

When the heat exchanger 42a of the second cooler 42 and the heat exchanger 43a of the third cooler 43 are stacked to interpose the second power card 32 with the insulation plates 32a and 32b disposed therebetween, the rear pipe portions 42c of the second cooler 42 and the front pipe portions 43b of the third cooler 43 are connected in the stacking direction.

Similarly, when the first cooler 41 and the second cooler 42 are stacked to interpose the first power card 31, the rear pipe portions 41c of the first cooler 41 and the front pipe portions 42b of the second cooler 42 are connected in the stacking direction. When the third cooler 43 and the fourth cooler 44 are stacked to interpose the third power card 33, the rear pipe portions 43c of the third cooler 43 and the front pipe portions 44b of the fourth cooler 44 are connected in the stacking direction. Furthermore, when the fourth cooler 44 and the fifth cooler 45 are stacked to interpose the fourth power card 34, the rear pipe portions 44c of the fourth cooler 44 and the front pipe portions 45b of the fifth cooler 45 are connected in the stacking direction. The front pipe portions 41b of the first cooler 41, the rear pipe portions 41c, the front pipe portions 42b, the rear pipe portions 42c, the front pipe portions 43b, the rear pipe portions 43c, the front pipe portions 44b, the rear pipe portions 44c, and the front pipe portions 45b connected in the stacking direction constitute the coolant supply pipe 46 and the coolant discharge pipe 47, which are coolant pipes each extending in the stacking direction. Coolant flowing into one of the front pipe portions 41b of the first cooler 41 from the front end of the coolant supply pipe 46 as shown by an arrow flows through the coolant supply pipe 46 in the stacking direction, while flowing from the right end to the left end of the heat exchangers 41a, 42a, 43a, 44a to cool the first to the fourth power cards 31 to 34 from both the front and rear surfaces, and then flows through the coolant discharge pipe 47 toward the front and out of the case 50.

As described above, the first to the fourth four power cards 31 to 34 and the first to the fifth five coolers 41 to 45 alternately stacked form the stack 90 with the insulation plates 31a to 34a and 31b to 34b interposed between the first to the fourth four power cards 31 to 34 and the first to the fifth five coolers 41 to 45. The insulation spacer 61, which is a flat insulation member, is attached between the front surface of the first cooler 41 located on the front end of the stack 90 as viewed in the stacking direction and the rear surface 51a of the front plate 51 of the case 50. The insulation spacer 62 and a metal flat spring 55 are placed between the rear surface of the fifth cooler 45 located on the rear end of the stack 90 as viewed in the stacking direction and a front surface 52a of the back plate 52 of the case 50. The flat spring 55 is pressed against the stack 90 to the front toward the front plate 51 of the case 50 to thereby closely contact the heat exchangers 41a to 45a of the first to the fifth coolers 41 to 45 with the front and rear surfaces of the first to the fourth power cards 31 to 34. As described above, the first cooler 41 is electrically insulated from the front plate 51 of the case 50 by the insulation spacer 61, and the fifth cooler 45 is insulated from the metal flat spring 55 and the back plate 52 of the case 50 by the insulation spacer 62.

The front pipe portion 41b of the first cooler 41 on the front end in the stacking direction penetrates a hole 51h, formed in the front plate 51 of the case 50, to the front side in the stacking direction and extends forward of the front plate 51. The front pipe portion 41b is attached to the hole 51h with an insulation tube 63 that serves as a different insulation member disposed in between.

As described above, the first to the fifth metal coolers 41 to 45 are attached to the metal case 50 in an electrically insulated state with the insulation spacers 61 and 62, which serve as insulation members, and the insulation tube 63, which serves as a different insulation member, placed between the first to the fifth coolers 41 to 45 and the metal case 50. As the remaining unillustrated portions of the first to the fifth coolers 41 to 45 and their adjacent portions of the case 50 also have additional insulation members disposed therebetween, the stack 90 and the case 50 are electrically insulated from each other.

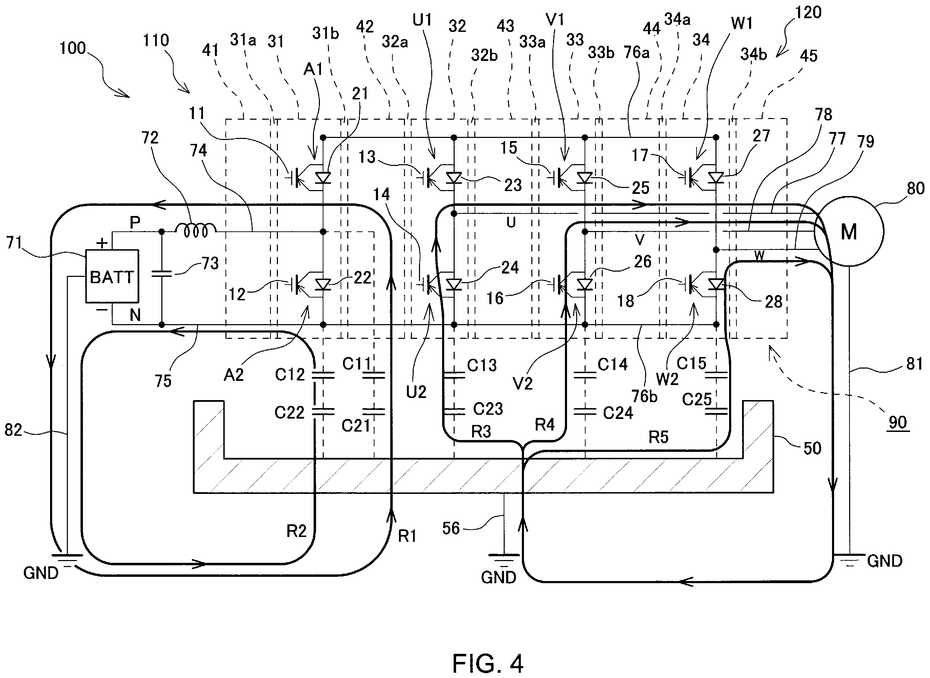

Next, a motor drive system, in which the power converter 100 converts direct current power from a battery 71 into alternating current power to drive a motor 80, will be described. As shown in FIG. 4, the power converter 100 includes a converter portion 110 for converting voltage of direct current power and an inverter portion 120 for driving the motor 80 by converting direct current power into alternating current power. The converter portion 110 includes the first power card 31, a reactor 72, and a smoothing capacitor 73. The inverter portion 120 includes the second to the fourth power cards 32 to 34.

The first power card 31 of the converter portion 110 includes an upper arm A1 and a lower arm A2 connected in series with each other. The upper arm A1 includes the first switching element 11 and the first diode 21 connected anti-parallel to the first switching element 11. The lower arm A2 includes the second switching element 12 and the second diode 22 connected anti-parallel to the second switching element 12. A P line 74 extending from a positive electrode of the battery 71 is connected to a connecting point between the upper arm A1 and the lower arm A2. The reactor 72 is connected in series to the P line 74. The other end of the lower arm A2 is connected to an N line 75 connected to a negative electrode of the battery 71. The other end of the upper arm A1 is connected to a high voltage line 76a of the inverter portion 120. Additionally, the N line 75 is connected to a low voltage line 76b of the inverter portion 120.

The second power card 32 constituting the inverter portion 120 includes a U phase upper arm U1 and a U phase lower arm U2 connected in series between the high voltage line 76a and the low voltage line 76b. The U phase upper arm U1 includes the third switching element 13 and the third diode 23, and the U phase lower arm U2 includes the fourth switching element 14 and the fourth diode 24. A U phase output line 77 is connected to a connecting point between the U phase upper arm U1 and the U phase lower arm U2. The U phase output line 77 is connected to a U phase terminal of the motor 80.

Similarly, the third power card 33 includes a V phase upper arm V1 and a V phase lower arm V2 connected in series between the high voltage line 76a and the low voltage line 76b, and the V phase upper arm V1 and the V phase lower arm V2 include the fifth and sixth switching elements 15 and 16 and the fifth and sixth diodes 25 and 26. A V phase output line 78 is connected to a connecting point between the V phase upper arm V1 and the V phase lower arm V2. The V phase output line 78 is connected to a V phase terminal of the motor 80. Similarly, the fourth power card 34 includes a W phase upper arm W1 and a W phase lower arm W2 connected in series between the high voltage line 76a and the low voltage line 76b, and the W phase upper arm W1 and the W phase lower arm W2 include the seventh and eighth switching elements 17 and 18 and the seventh and eighth diodes 27 and 28. A W phase output line 79 is connected to a connecting point between the W phase upper arm W1 and the W phase lower arm W2. The W phase output line 79 is connected to a W phase terminal of the motor 80.

The case 50 is connected to a ground GND with a ground wire 56, the motor 80 is grounded to the ground GND with a ground wire 81, and the battery 71 is grounded to the ground GND with a ground wire 82.

Referring to FIG. 4, stray capacitances C11 to C15 refer to those that would occur between the P line 74 and the ground GND, between the N line 75 and the ground GND, between the U phase output line 77 and the ground GND, between the V phase output line 78 and the ground GND, and between the W phase output line 79 and the ground GND, in the converter portion 110 when the insulation spacers 61 and 62 and the insulation tube 63 are not provided. Stray capacitances C21 to C25 refer to those between the first to the fifth coolers 41 to 45 and the case 50 formed by the insulation spacers 61 and 62 and the insulation tube 63. As the insulation spacers 61 and 62 and the insulation tube 63 are disposed between the first to the fifth coolers 41 to 45 and the case 50, the stray capacitances C21 to C25 refer to those connected in series respectively to the stray capacitances C11 to C15 that would occur when the insulation spacers 61 and 62 and the insulation tube 63 are not provided.

In response to switching operation of the first to the eighth switching elements 11 to 18 of the power converter 100, circuits R1 to R5 through which common mode current flows shown as R1 to R5 are created among the P line 74, the N line 75, the U phase output line 77, the V phase output line 78, the W phase output line 79, and the ground GND, due to the presence of the stray capacitances C11 to C15, and C21 to C25. As shown in FIG. 4, the circuit R1 carries common mode current from the first power card 31, through the first cooler 41, the P line 74, the battery 71, the ground wire 82 of the battery 71, the ground GND, the ground wire 56, the case 50, the stray capacitances C21 and C11, the second cooler 42, to the first power card 31. The circuit R2 is a circuit that runs from the first power card 31, through the N line 75, the ground wire 82 of the battery 71, the ground GND, the stray capacitances C22 and C12, and returns to the first power card 31. The circuit R3 is a circuit that runs from the second power card 32, through the U phase output line 77, the ground wire 81 of the motor 80, the ground GND, stray capacitances C23 and C13, and returns to the second power card 32. Similarly, the circuit R4 is a circuit that runs from the third power card 33, through the V phase output line 78, the ground wire 81 of the motor 80, the ground GND, the stray capacitances C24 and C14, and returns to the third power card 33. The circuit R5 is a circuit that runs from the fourth power card 34, through the W phase output line 79, the ground wire 81 of the motor 80, the ground GND, the stray capacitances C25 and C15, and returns to the fourth power card 34.

Coupling stray capacitance C5 of the circuit R5 will be described herein. The coupling stray capacitance C5 refers to the stray capacitance between the W phase output line 79 connected to the fourth power card 34 including the seventh and the eighth switching elements 17 and 18 and the ground GND, that is the stray capacitance between the seventh and the eighth switching elements 17 and 18 and the ground GND. As described above, the coupling stray capacitance C5 of the circuit R5 refers to those in which the stray capacitance C15 and the stray capacitance C25 are connected in series, and the relationship of Equation I below holds.

$$1/C5 = 1/C15 + 1/C25 \quad \text{Equation I}$$

From Equation I,

$$C5 = (C15 \times C25) / (C15 + C25) \qquad \text{Equation II}$$

When the first to the fifth metal coolers 41 to 45 and the metal case 50 are connected so as to be electrically conductive, the amount of the stray capacitance C15 between the fourth power card 34 and the ground GND is significantly large; for example, on the order of 1,000 picofarads (pF). The stray capacitance C25 described herein refers to the stray capacitance between the first to the fifth coolers 41 to 45 and the case 50 formed when the first to the fifth metal coolers 41 to 45 are attached to the case 50 with the insulation spacers 61 and 62 and the insulation tube 63 disposed therebetween. The amount of the stray capacitance C25 is significantly small with respect to the amount of the stray capacitance C15 and 1/100 or less of the C15; for example, about several picofarads (pF). Therefore, the coupling stray capacitance C5 calculated from the above Equation II is 1/100 or less of the coupling stray capacitance C5 that would occur when the insulation spacers 61 and 62 and the insulation tubes 63 are not provided. Similarly, the coupling stray capacitances C1 to C4 of the circuits R1 to R4 are also 1/100 or less of the stray capacitances of C11 to C14.

The coupling stray capacitances C1 and C2 of the circuits R1 and R2 refer to the stray capacitances between the P line 74 and the N line 75 connected to the first power card 31 including the first and the second switching elements 11 and 12 and the ground GND, which are the stray capacitances between the first and the second switching elements 11 and 12 and the ground GND. The coupling stray capacitance C3 of the circuit R3 refers to the stray capacitance between the U phase output line 77 connected to the second power card 32 including the third and the fourth switching elements 13 and 14 and the ground GND, which is the stray capacitance between the third and the fourth switching elements 13 and 14 and the ground GND. Similarly, the coupling stray capacitance C4 of the circuit R4 refers to the stray capacitance between the V phase output line 78 connected to the third power card 33 including the fifth and the sixth switching elements 15 and 16 and the ground GND.

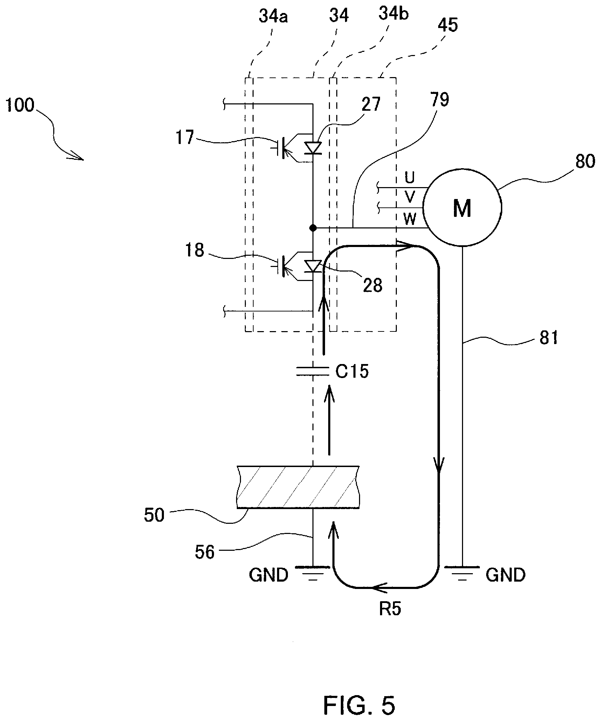

In contrast, as shown in FIG. 5, when the case 50 and the fifth cooler 45 are in electrical contact with each other and the insulation spacers 61 and 62 and the insulation tube 63 are not provided, a stray capacitance between the fourth power card 34 and the ground GND is the stray capacitance C15, and large common mode current flows through the circuit R5 to thereby generate a large amount of common mode noise.

As described above, by attaching the first to the fifth coolers 41 to 45 to the case 50 with the insulation spacers 61 and 62 and the insulation tube 63 disposed between the first to the fifth coolers 41 to 45 and the case 50, the coupling stray capacitances C1 to C5 of the circuits R1 to R5 or the coupling stray capacitances C1 to C5 between the first to the fourth power cards 31 to 34 and the ground GND become 1/100 or less of the stray capacitances C11 to C15 that would occur when the insulation spacers 61 and 62 and the insulation tubes 63 are not provided. This increases the impedance of the circuits R1 to R5, suppressing common mode current flowing through the circuits R1 to R5, and reduces occurrence of common mode noise.

Although the above description has been presented for arrangements in which the first to the fifth coolers 41 to 45 are attached to the case 50 with the insulation spacers 61 and 62 and the insulation tube 63 disposed between the first to the fifth coolers 41 to 45 and the case 50, other arrangements may also be implemented. For example, the stack 90 including the first to the fifth coolers 41 to 45 may be attached to the case 50 using, for example, ceramic insulation bolts, nuts, and bushings so that the stack 90 is attached to the case 50 in an electrically insulated manner. The above description has been presented for the first to the fifth coolers and the case 50 made of metal such as aluminum, and other materials such as conductive resins and composite materials may be used for the first to the fifth coolers and the case 50.

Although the above description has been presented for arrangements in which the front pipe portion 41b of the first cooler 41 is attached to the case 50 with the insulation tube 63 disposed in between, other arrangements may also be implemented. For example, the hole 51h formed on the front plate 51 may be configured to have a larger inner diameter than the outer diameter of the front pipe portion 41b, such that the front pipe portion 41b does not contact the front plate 51 to achieve insulation with an air space formed therebetween. This configuration achieves electrical insulation between the front pipe portion 41b and the case 50 in a simple manner.

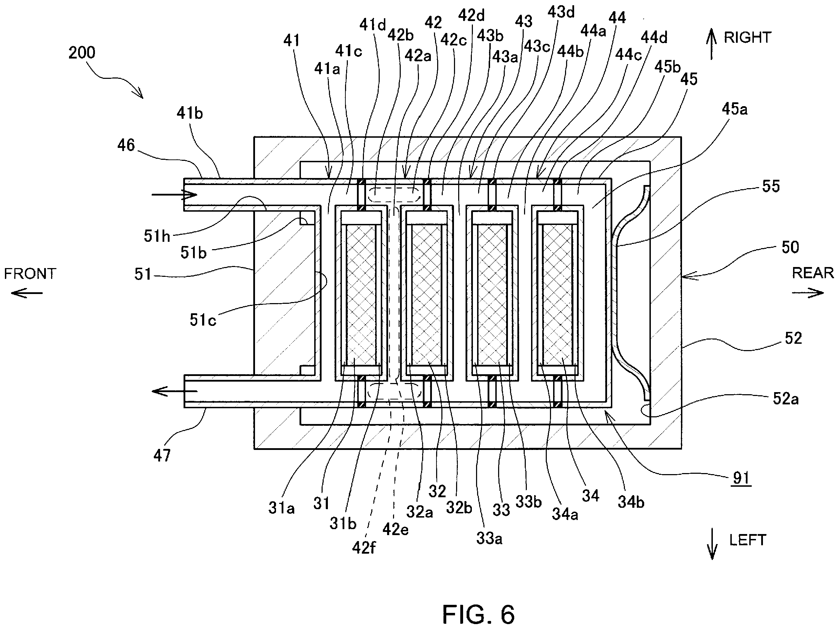

With reference to FIG. 6, a power converter 200 according to another embodiment will be described below. The same reference numerals are assigned to elements corresponding to those described for the power converter 100 with reference to FIGs. 1 to 5 and the description thereof will not be repeated.

As shown in FIG. 6, the power converter 200 includes a stack 91 including the first to the fourth four power cards 31 to 34 and the first to the fifth five coolers 41 to 45 alternately stacked with the insulation plates 31a to 34a and 31b to 34b interposed between the first to the fourth four power cards 31 to 34 and the first to the fifth five coolers 41 to 45. In the stack 91, insulation rings 41d to 44d placed between the front pipe portions 42b to 45b and the rear pipe portions 41c to 44c of the first to the fifth coolers 41 to 45 connect the first to the fifth coolers 41 to 45 to each other in an electrically insulated manner.

As shown in FIG. 6, the first cooler 41 on the front end as viewed in the stacking direction of the stack 91 has a front surface attached to the case 50 so as to contact a rear surface 51c of a projection 51b projected backward of the front plate 51 of the case 50. The fifth cooler 45 on the rear end as viewed in the stacking direction of the stack 91 has a rear surface attached to the back plate 52 of the case 50 by use of a metal flat spring 55. The front pipe portion 41b of the first cooler 41 is retained by the hole 51h formed in the front plate 51. As described, the first cooler 41 is attached to the case 50 so as to be electrically conductive with the case 50. The fifth cooler 45 is attached so as to be electrically conductive with the back plate 52 of the case 50 with the metal flat spring 55 disposed therebetween.

In attaching the first and the fifth coolers 41 and 45 to the case 50 in an electrically conductive manner, if the stack 90 of the power converter 100 does not include the insulation rings 41d to 44d disposed between the front pipe portions 42b to 45b and the rear pipe portions 41c to 44c, individual stray capacitances between the first to the fourth power cards 31 to 34 interposed between the first to the fifth coolers 41 to 45 and the ground GND are electrically connected in parallel to the ground GND. Accordingly, the stray capacitance between the stack 90 and the ground GND becomes the total of the stray capacitances between the first to the fourth power cards 31 to 34 and the ground GND, which is a large amount of stray capacitance.

In the power converter 200, the first to the fifth coolers 41 to 45 are connected to each other with the insulation rings 41d to 44d disposed between the front pipe portions 42b to 45b and the rear pipe portions 41c to 44c. This prevents individual stray capacitances between the first to the fourth power cards 31 to 34 interposed between the first to the fifth coolers 41 to 45 and the ground GND from being electrically connected in parallel to the ground GND. Accordingly, the stray capacitance between the stack 91 and the ground GND is the stray capacitance between each of the first to the fourth power cards 31 to 34 and the ground GND, not the total of the individual stray capacitances between the first to the fourth power cards 31 to 34 and the ground GND. The stray capacitance between the stack 91 and the ground GND is therefore reduced to about 1/5 from the stray capacitance which would occur when the stack 90 is attached to the case 50 in an electrically conductive state.

As described above, the power converter 200 can reduce the stray capacitances between the first to the fourth power cards 31 to 34 and the ground GND, suppress common mode current, and reduce common mode noise. In the power converter 200, common mode noise can be suppressed even when the first to the fifth coolers 41 to 45 and the case 50 are not insulated or insulation is lost.

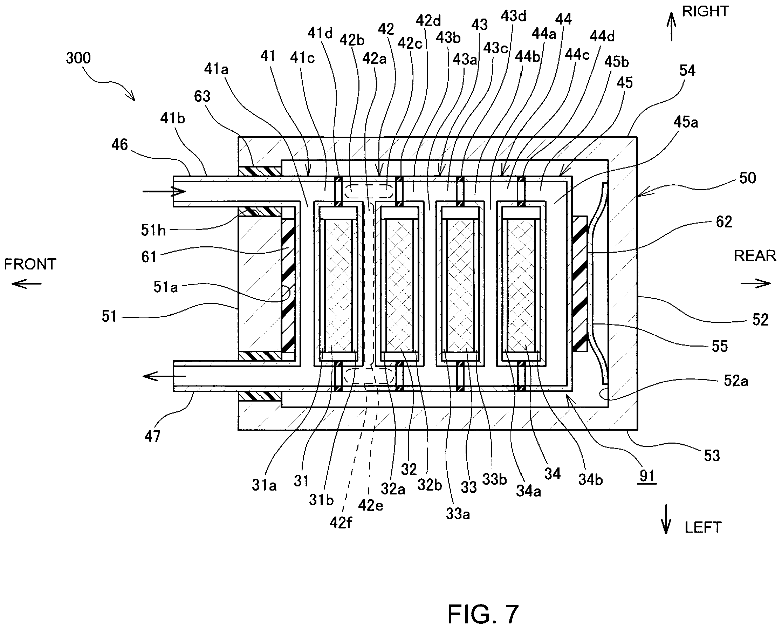

A power converter 300 according to another embodiment will be described with reference to FIG. 7. The same reference numerals are assigned to elements corresponding to those previously described for the power converter 100 with reference to FIGs. 1 to 5 and for the power converter 200 with reference to FIG. 6, and the description thereof will not be repeated.

The power converter 300 includes the stack 91 including the first to the fifth coolers 41 to 45 connected to be electrically insulated from each other with the insulation rings 41d to 44d disposed between the front pipe portions 42b to 45b and the rear pipe portions 41c to 44c of the first to the fifth coolers 41 to 45, as described with reference to FIG. 6, and the stack 91 is attached to the metal case 50 with the insulation spacers 61 and 62 and the insulation tube 63 disposed therebetween, as described with reference to FIGs. 1 to 5.

As the power converter 300 reduces the coupling stray capacitances C1 to C5 as described for the power converter 100 and prevents parallel connection of the individual stray capacitances between the first to the fourth power cards 31 to 34 and the ground GND as described for the power converter 200, the stray capacitance between the stack 91 and the ground GND can be significantly reduced, and common mode noise can be reduced more effectively.

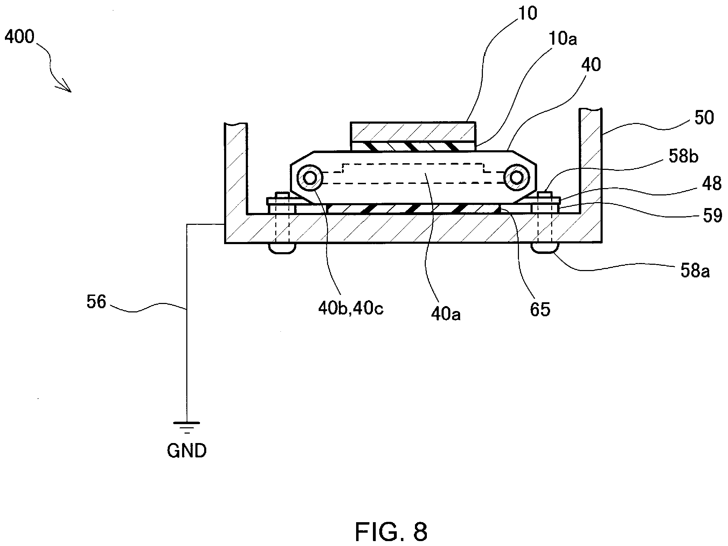

Next, another power converter 400 will be described with reference to FIG. 8. The above-described power converters 100, 200, and 300 are configured such that the stacks 90 and 91 including a stack of the power cards 30 each housing the switching elements 10 and the diodes 20 therein and the coolers 40 are attached to the case 50. The power converter 400 includes a plurality of the switching elements 10 placed on the upper surface of the coolers 40 with an insulation sheet 10a disposed therebetween. The coolers 40 are placed on the bottom plate of the case 50 with an insulation spacer 65 disposed in between, and an attaching arm 48 for the case 50 is configured to be attached to the bottom of the case 50 by use of insulation bushings 59 made of, for example, ceramics, and ceramic insulation bolts 58a and nuts 58b. The insulation spacer 65, the insulation bushings 59, the bolts 58a, and the nuts 58b constitute insulation members.

In the power converter 400, similarly to the power converter 100, a minute stray capacitance formed by the insulation spacer 65, the insulation bushings 59, the bolts 58a, and the nuts 58b is connected in series with a large stray capacitance between the switching elements 10 and the coolers 40 and the ground GND, thereby reducing the coupling stray capacitance between the switching element 10 and the ground GND, and further reducing common mode noise.

**Claims**

1. A power converter comprising:

switching elements (10);

an electrically conductive cooler (40) that is in contact with the switching elements (10) with an insulation plate (30a, 30b) disposed between the cooler (40) and the switching elements (10); and

a grounded electrically conductive case (50) that houses therein the switching elements (10) and the cooler (40), wherein the power converter converts power through switching operation of the switching elements (10), and wherein the cooler (40) is attached to the case with an insulation member (61, 62) disposed between the cooler (40) and the case (50).

2. The power converter according to claim 1, comprising:

a plurality of power cards (30) each housing switching elements (10); and

a plurality of electrically conductive coolers (40),

wherein the plurality of coolers(40) and the plurality of power cards (30) are stacked with an insulation plate (30a, 30b) interposed between each of the plurality of coolers (40) and its adjacent power card (30) to form a stack, and

wherein the stack is attached to the case (50) with an insulation member (61, 62) interposed between each of two of the plurality of coolers (40) that are located at opposite ends in a stacking direction and the case (50).

3. The power converter according to claim 2,
wherein each of the plurality of coolers (40) comprises:

a plate heat exchanger having a coolant flow passage therein and having an outer surface that is in contact with a surface of its adjacent power card (30) with an insulation plate (30a, 30b) disposed between the heat exchanger (41a~45a) and the power card (30); and

pipe portions (41b~45b, 41c~44c) each connected to one of two ends of the heat exchanger (41a~45a) and extending in the stacking direction, each of the pipe portions (41b~45b, 41c~44c) having an inner through hole that is in communication with the coolant flow passage of the heat exchanger (41a~45a),

wherein the pipe portions (41b~45b, 41c~44c) of the plurality of coolers (40) with the heat exchangers (41a~45a) placed between the plurality of power cards (30) are connected to each other in the stacking direction to form coolant pipes that extend in the stacking direction,

wherein the pipe portions (41b) of one of the plurality of coolers (40) that is located at one end in the stacking direction penetrate and extend out the case (50), and

wherein the pipe portions (41b) that penetrate the case (50) are attached to the case (50) with a different insulation member (63) disposed between each of the pipe portions(41b) and the case (50).

4. The power converter according to claim 3,
wherein the pipe portions (41b~45b, 41c~44c) of the plurality of coolers (40) are connected to each other with an insulation ring (41d~44d) disposed between each of the pipe portions (41b~45b, 41c~44c) and its adjacent pipe portion.

5. A power converter comprising:

a plurality of power cards (30) each housing switching elements (10);

a plurality of electrically conductive coolers (40), each of which is in contact with one or more power cards (30) of the plurality of power cards (30) with an insulation plate (30a, 30b) disposed between the cooler (40) and each of the one or more power cards (30); and

a grounded electrically conductive case (50) that houses therein the plurality of power cards (30) and the plurality of coolers (40);

wherein the power converter converts power through switching operation of the switching elements (10),

wherein the plurality of coolers (40) and the plurality of power cards (30) are stacked with the insulation plates (30a, 30b) interposed between the plurality of coolers (40) and the plurality of power cards (30) to form a stack, wherein each of the plurality of coolers (40) comprises:

a plate heat exchanger (41a~45a) having a coolant flow passage therein and having an outer surface that is in contact with a surface of its adjacent power cards (30) with an insulation plate (30a, 30b) disposed between the heat exchanger (41a~45a) and the power card (30); and

pipe portions (41b~45b, 41c~44c) each connected to one of two ends of the heat exchanger (41a~45a) and extending in the stacking direction, each of the pipe portions (41b~45b, 41c~44c) having an inner through hole that is in communication with the coolant flow passage of the heat exchanger (41a~45a), and wherein the pipe portions (41b~45b, 41c~44c) of the plurality of coolers (40) with the heat exchangers (41a~45a) placed between the plurality of power cards (30) are connected to each other in the stacking direction with an insulation ring (41d~44d) disposed between each of the pipe portions and its adjacent pipe portion to form coolant pipes that extend in the stacking direction.

FIG. 1

FIG. 2

EP 3 968 742 A1

FIG. 3

FIG. 4

FIG. 5

FIG. 6

FIG. 7

FIG. 8

Europäisches
Patentamt

European
Patent Office

Office européen
des brevets

## EUROPEAN SEARCH REPORT

**Application Number**

EP 21 19 4694

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | JP 2013 198255 A (TOYOTA MOTOR CORP) 30 September 2013 (2013-09-30) | 1-3 | INV. H05K7/14 |
| A | * paragraphs [0005] - [0030] * | 4,5 | H05K7/20 |
| A | US 2016/192539 A1 (SUGITA MASAYUKI [JP]) 30 June 2016 (2016-06-30) * paragraphs [0013] - [0039] * | 1-5 | |

**TECHNICAL FIELDS SEARCHED (IPC)**

H05K

The present search report has been drawn up for all claims

| Place of search | Date of completion of the search | Examiner |
|---|---|---|
| The Hague | 26 January 2022 | Davenport, Kevin |

EPO FORM 1503 03.82 (P04C01)

## ANNEX TO THE EUROPEAN SEARCH REPORT
## ON EUROPEAN PATENT APPLICATION NO.

EP 21 19 4694

This annex lists the patent family members relating to the patent documents cited in the above-mentioned European search report.
The members are as contained in the European Patent Office EDP file on
The European Patent Office is in no way liable for these particulars which are merely given for the purpose of information.

26-01-2022

| Patent document cited in search report | | Publication date | Patent family member(s) | | Publication date |
|---|---|---|---|---|---|
| JP 2013198255 | A | 30-09-2013 | NONE | | |
| US 2016192539 | A1 | 30-06-2016 | CN | 105743326 A | 06-07-2016 |
| | | | JP | 6187448 B2 | 30-08-2017 |
| | | | JP | 2016119437 A | 30-06-2016 |
| | | | US | 2016192539 A1 | 30-06-2016 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2020152574 A
- JP 2013084800 A
- JP H09298889 A
- JP 2017162988 A